# EUROPEAN PATENT APPLICATION

(11) **EP 2 980 874 A1**
(43) Date of publication of application: **03.02.2016**
(21) Application number: 14773078.2
(22) Date of filing: 25.03.2014
(51) Int. Cl.: H01L 43/06, C23C 16/30, H01L 21/205

(54) **COMPOUND SEMICONDUCTOR STACK AND SEMICONDUCTOR DEVICE**

(30) Priority: 25.03.2013 JP 2013062469
(71) Applicant: Asahi Kasei Microdevices Corporation, Tokyo 101-8101 (JP); National Institute Of Advanced Industrial Science, Tokyo 100-8921 (JP)
(72) Inventor: YOSHIKAWA, Akira, Tokyo 101-8101 (JP); MORIYASU, Yoshitaka, Tokyo 101-8101 (JP); OGURA, Mutsuo, Tsukuba-shi Ibaraki 305-8568 (JP)
(74) Representative: Hoffmann Eitle
(86) International application number: PCT/JP2014/001703
(87) International publication number: WO 2014/156123

(57) **Abstract**

There is provided a compound semiconductor stack including a substrate (101) of which electrical resistance is greater than or equal to 1x10⁵ Ωcm, a first compound semiconductor layer (102) which is formed on the substrate (101), and contains In and Sb doped with carbon, and a second compound semiconductor layer (103) which is formed on the first compound semiconductor layer (102), has a carbon concentration less than a carbon concentration of the first compound semiconductor layer (102), and contains In and Sb. A film thickness of the first compound semiconductor layer (102) is greater than or equal to 0.005 µm and less than or equal to 0.2 µm. In addition, the carbon concentration of the first compound semiconductor layer (102) is greater than or equal to 1x10¹⁵cm⁻³ and less than or equal to 5x10¹⁸cm⁻³.

## Description

### Technical Field

The present invention relates to a compound semiconductor stack provided with a compound semiconductor multilayer film containing In and Sb, and a semiconductor device.

### Background Art

It has been known that an InSb thin film has high electron mobility, and thus is suitable as a material of a hall device or a magnetic sensor. In order to apply the InSb thin film to a magnetic sensor, high sensitivity and low power consumption are required. In other words, high electron mobility and a thin film thickness are essential. In these electron devices, the InSb thin film is formed on a GaAs or InP substrate which is a semi-insulating substrate in order to prevent an electric current leakage (refer to NPL 1).

### Citation List

### Non Patent Literature

NPL 1: Oh et.al., "Journal of Applied Physics", Volume 66, October, 1989, p. 3618-3621
NPL 2: Liu et.al., "Journal of Vacuum Science & Technology B", Volume 14, May, 1996, p. 2339-2342

### Summary of Invention

### Technical Problem

As disclosed in NPL 1, when the InSb thin film is formed on the GaAs or InP substrate, a large lattice mismatch exists between the substrate and InSb, and thus a misfit dislocation or a crystal defect exists in the formed InSb layer in large amounts. This transition or defect generates excessive electrons, and thus remarkably decreases the electron mobility.

In addition, in general, the crystal defect of the thin film due to the mismatch with the substrate is remarkable in the vicinity of an interface between the film and the substrate. The density of the crystal defect has been decreased according to the growth of the thin film, but the InSb layer in a lower portion which has a high crystal defect concentration and low electron mobility also contributes to electrical properties, and thus the entire electron mobility decreases due to the crystal defect. When a comparatively thick thin film of several micron order is formed, an influence due to the defect in the vicinity of the interface is minimized, but it is not practical for manufacturing a device, and thus resistance decreases due to an increase in the film thickness, and power consumption increases.

In order to solve this problem, a method has been known in which an AlₓIn₁₋ₓSb (x ≥ 0.07) film having high resistance is formed on a GaAs substrate as a buffer layer relaxing a lattice mismatch, and an InSb film is formed thereon (refer to NPL 2).

However, when the AlInSb buffer layer is used, the crystallinity of the InSb film formed on the buffer layer is deteriorated, and thus in order to avoid such a problem, it is necessary to make the AlInSb buffer layer thick, but an adverse influence that the entire film thickness increases occurs.

As described above, a technology of forming the InSb film of which the entire film thickness is thin while maintaining high mobility and high crystallinity has not been known yet.

Therefore, the present invention has been made in consideration of such a situation, and an object thereof is to provide a compound semiconductor stack including a thin compound semiconductor multilayer film having high mobility and excellent crystallinity in which an occurrence of excessive electrons in the vicinity of the interface between the film and the substrate is suppressed, and a semiconductor device.

### Solution to Problem

As a result of intensive studies for solving the problems described above, the present inventors have found that a compound semiconductor stack including a substrate of which electrical resistance is greater than or equal to 1x10⁵ Ωcm; a first compound semiconductor layer which is formed on the substrate, and contains In and Sb doped with carbon; and a second compound semiconductor layer which is formed on the first compound semiconductor layer, and contains In and Sb, in which a film thickness of the first compound semiconductor layer is greater than or equal to 0.005 µm and less than or equal to 0.2 µm, and a carbon concentration of the first compound semiconductor layer is greater than or equal to 1x10¹⁵ cm⁻³ and less than or equal to 5x10¹⁸ cm⁻³, and thus have completed the present invention.

That is, a compound semiconductor stack according to an aspect of the present invention includes a substrate of which electrical resistance is greater than or equal to 1x10⁵ Ωcm, a first compound semiconductor layer which is formed on the substrate, and contains In and Sb doped with carbon, and a second compound semiconductor layer which is formed on the first compound semiconductor layer, has a carbon concentration less than a carbon concentration of the first compound semiconductor layer, and contains In and Sb, in which a film thickness of the first compound semiconductor layer is greater than or equal to 0.005 µm and less than or equal to 0.2 µm, and the carbon concentration of the first compound semiconductor layer is greater than or equal to 1x10¹⁵ m⁻³ and less than or equal to 5x10¹⁸ cm⁻³.

In addition, in the compound semiconductor stack described above, the substrate may be Si or GaAs.

In addition, in the compound semiconductor stack described above, the first compound semiconductor layer is a buffer layer relaxing a lattice mismatch between the substrate and the second compound semiconductor layer, and the second compound semiconductor layer is an active layer functioning as at least a part of an element.

A semiconductor device according to another aspect of the present invention is able to be obtained by using the compound semiconductor stack described above.

### Advantageous Effects of Invention

According to the aspect of the present invention, a thin compound semiconductor multilayer film having high mobility and excellent crystallinity is able to be realized in which an occurrence of excessive electrons in the vicinity of an interface between the thin compound semiconductor multilayer film and a substrate is suppressed.

### Brief Description of Drawing

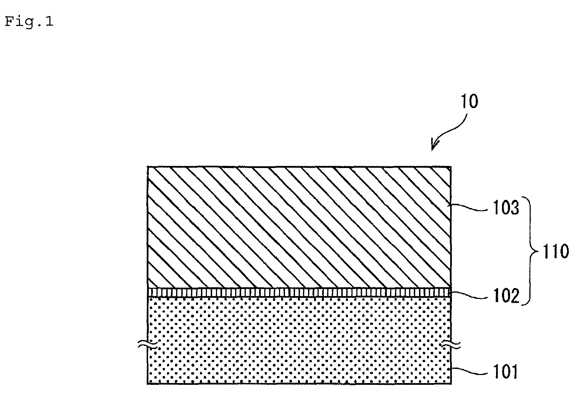

FIG. 1 is a sectional view illustrating a compound semiconductor stack according to the present invention.

### Description of Embodiment

Hereinafter, an embodiment of the present invention (hereinafter, referred to as "this embodiment") will be described in detail with reference to the drawing.

### [Compound Semiconductor Stack]

A compound semiconductor stack 10 of this embodiment illustrated in FIG. 1 includes a substrate 101 of which electrical resistance is greater than or equal to 1x10⁵ Ωcm, a first compound semiconductor layer 102 which is formed on the substrate, has a film thickness of greater than or equal to 0.005 µm and less than or equal to 0.2 µm, has a carbon concentration of greater than or equal to 1x10¹⁵ cm⁻³ and less than or equal to 5x10¹⁸ cm⁻³, and contains In and Sb, and a second compound semiconductor layer 103 which is formed on the first compound semiconductor layer 102, has a carbon concentration (that is, a doping amount) less than that of the first compound semiconductor layer 102, and contains In and Sb. A compound semiconductor multilayer film 110 is configured of the first compound semiconductor layer 102 and the second compound semiconductor layer 103.

By including the first compound semiconductor layer 102 which has a film thickness of greater than or equal to 0.005 µm and less than or equal to 0.2 µm, has a carbon concentration of greater than or equal to 1x10¹⁵ cm⁻³ and less than or equal to 5x10¹⁸ cm⁻³, and contains In and Sb between the substrate 101 and the second compound semiconductor layer 103, an occurrence of excessive electrons in the vicinity of an interface between the substrate 101 and the compound semiconductor multilayer film 110 is suppressed. In addition, the first compound semiconductor layer 102 relaxes a lattice mismatch between the substrate 101 and the second compound semiconductor layer 103.

### [Substrate]

The substrate 101 in the compound semiconductor stack of this embodiment is not particularly limited insofar as the electrical resistance of the substrate is greater than or equal to 1x10⁵ Ωcm. A substrate having the same crystal symmetry as that of InSb is preferable, and since an inexpensive and large-sized substrate is easily obtained, it is preferable that the substrate 101 is either Si or GaAs.

### [First Compound Semiconductor Layer]

The first compound semiconductor layer 102 in the compound semiconductor stack of this embodiment has a film thickness of greater than or equal to 0.005 µm and less than or equal to 0.2 µm, has a carbon concentration of greater than or equal to 1x10¹⁵ cm⁻³ and less than or equal to 5x10¹⁸ cm⁻³, and is formed of a compound semiconductor containing In and Sb. Specifically, as the first compound semiconductor layer 102, InSb, InAlSb, InGaSb, InAsSb, InPSb, InAsPSb, InAlGaSb, InAlAsSb, InGaAsSb, InGaPSb, InAlPSb, InAlGaAsSb, InAlGaPSb, and the like which are doped with carbon are included, but the first compound semiconductor layer 102 is not limited thereto.

From a viewpoint of the entire film thickness and an electrically insulating layer, the film thickness of the first compound semiconductor layer 102 is greater than or equal to 0.005 µm and less than or equal to 0.2 µm, is preferably greater than or equal to 0.005 µm and less than 0.2 µm, is more preferably greater than or equal to 0.005 µm and less than or equal to 0.15 µm, and is even more preferably greater than or equal to 0.01 µm and less than or equal to 0.15 µm. When the film thickness of the first compound semiconductor layer is less than 0.005 µm, the first compound semiconductor layer becomes a low resistive layer, and thus an effect of preventing an electric current leakage is not sufficiently obtained, and the mobility also decreases. In addition, when the film thickness of the first compound semiconductor layer is greater than 0.2 µm, excessive holes are generated beyond an effect of suppressing an occurrence of excessive electrons in the vicinity of the interface between the first compound semiconductor film and the substrate, and the mobility of the film decreases, and thus it is not preferable. In addition, the film thickness of the first compound semiconductor layer 102 indicates the full width at half maximum of a peak including a peak value of the carbon concentration described later when the compound semiconductor stack is subjected to secondary ion mass spectrometry (SIMS) from a front surface in a depth direction.

From a viewpoint of applying a necessary and sufficient carbon amount for cancelling out the excessive electrons, the carbon concentration of the first compound semiconductor layer 102 is greater than or equal to 1x10¹⁵ cm⁻³ and less than or equal to 5x10¹⁸ cm⁻³, is preferably greater than or equal to 5x10¹⁵ cm⁻³ and less than or equal to 3x10¹⁸ cm⁻³, is more preferably greater than or equal to 1x10¹⁶ cm⁻³ and less than or equal to 2x10¹⁸ cm⁻³, and is even more preferably greater than or equal to 5x10¹⁶ cm⁻³ and less than or equal to 2x10¹⁸ cm⁻³. When the doping amount of carbon excessively increases, the resistivity of the first compound semiconductor layer decreases due to the generated excessive holes, and the mobility decreases due to a hole current, and thus it is not practically preferable. In addition, when the doping amount excessively decreases, compensation with respect to the excessive electrons is not sufficiently performed, and thus an occurrence of a leak electric current is caused. The carbon concentration of the first compound semiconductor layer 102 indicates a peak value of the carbon concentration when the compound semiconductor stack is subjected to secondary ion mass spectrometry (SIMS) from the front surface in the depth direction.

### [Second Compound Semiconductor Layer]

The second compound semiconductor layer 103 in the compound semiconductor stack of this embodiment is not particularly limited insofar as the second compound semiconductor layer 103 has a carbon concentration less than that of the first compound semiconductor layer, and contains In and Sb. Specifically, as the second compound semiconductor layer 103, InSb, InAlSb, InGaSb, InAsSb, InPSb, InAsPSb, InAlGaSb, InAlAsSb, InGaAsSb, InGaPSb, InAlPSb, InAlGaAsSb, InAlGaPSb, and the like are included, but the second compound semiconductor layer 103 is not limited thereto.

From a viewpoint of relaxing a lattice mismatch, it is preferable that the second compound semiconductor layer 103 has the same material as that of the first compound semiconductor layer 102 except for carbon which is a dopant. From a viewpoint of obtaining a compound semiconductor layer having high mobility, it is preferable that the second compound semiconductor layer 103 is InSb. The film thickness of the second compound semiconductor layer 103 is not particularly limited, and it is preferable that the film thickness of the second compound semiconductor layer 103 is greater than or equal to 0.5 µm and less than or equal to 3 µm from a viewpoint of industrial manufacturing.

Furthermore, the carbon concentration of the second compound semiconductor layer 102, for example, is less than or equal to a lower limit of the detection of SIMS.

### [Application]

A plurality of compound semiconductors, a protective film, or an electrode is able to be further formed on the second compound semiconductor layer 103. In this case, a substance as the compound semiconductor is not particularly limited. In addition, the doping is not also particularly limited.

### [Manufacturing Method of Compound Semiconductor Stack]

Next, a manufacturing method of the compound semiconductor stack of this embodiment will be described.

The first compound semiconductor layer 102 is formed on the substrate 101 illustrated in FIG. 1, for example, by using a metal organic chemical vapor deposition (MOCVD) device. The growth temperature of the first compound semiconductor layer 102 is not particularly limited, and from a viewpoint of the decomposition rate of a raw material and the melting point of InSb, it is preferable that the growth temperature of the first compound semiconductor layer 102 is higher than or equal to 220°C and lower than or equal to 530°C, and it is more preferable that the growth temperature of the first compound semiconductor layer 102 is higher than or equal to 220°C and lower than or equal to 400°C. When the growth temperature of the first compound semiconductor layer is higher than or equal to 220°C, the decomposition rate of the raw material is excellent and a growth rate does not become slow, and a great amount of time is not required for growing a desired film thickness, and thus it is preferable. In addition, when the growth temperature of the first compound semiconductor layer is lower than or equal to 530°C, a part of a grown film or the entire grown film is not melted, and the crystallinity is not remarkably deteriorated, and thus it is preferable. A device used for forming the first compound semiconductor layer 102 is not particularly limited, and various devices which perform molecular-beam epitaxy, electron-beam deposition, resistive heating deposition, chemical vapor deposition, and the like are able to be used. The raw material used for forming the first compound semiconductor layer 102 is not particularly limited, and as the raw material of InSb, trimethyl indium (TMIn), and trisdimethyl aminoantimony (TDMASb) are able to be used, and as a doping raw material, carbon tetrabromide (CBr₄) and the like are able to be used. Raw material carrier gas is not particularly limited, and from a viewpoint of not including impurities, it is preferable that hydrogen or nitrogen having a guaranteed pure grade is used.

Next, the second compound semiconductor layer 103 is formed on the first compound semiconductor layer 102, for example, by using a MOCVD device. The growth temperature of the second compound semiconductor layer 103 is not particularly limited, and it is preferable that the growth temperature of the second compound semiconductor layer 103 is higher than or equal to 220°C and lower than or equal to 530°C from the decomposition rate of the raw material and the melting point of InSb. When the growth temperature of the second compound semiconductor layer is higher than or equal to 220°C, the decomposition rate of the raw material is excellent and a growth rate does not become slow, and a great amount of time is not required for growing a desired film thickness, and thus it is preferable. In addition, when the growth temperature of the second compound semiconductor layer is lower than or equal to 530°C, a part of a grown film or the entire grown film is not melted, and the crystallinity is not remarkably deteriorated, and thus it is preferable.

A device used for forming the second compound semiconductor layer 103 is not particularly limited, and various devices which perform molecular-beam epitaxy, electron-beam deposition, resistive heating deposition, chemical vapor deposition, and the like are able to be used. The raw material used for forming the second compound semiconductor layer 103 is not particularly limited, and as the raw material of InSb, trimethyl indium (TMIn), trisdimethyl aminoantimony (TDMASb), and the like are able to be used. Raw material carrier gas is not particularly limited, and from a viewpoint of not including impurities, it is preferable that hydrogen or nitrogen having a guaranteed pure grade is used.

### [Semiconductor Device]

In addition, a semiconductor device may be manufactured by using the compound semiconductor stack of this embodiment. Specifically, the second compound semiconductor layer of the compound semiconductor stack may be an active layer. As a specific example of the semiconductor device using the second compound semiconductor layer containing In and Sb as the active layer, a magnetic sensor, a hall device, an infrared sensor device, or the like is included. All of them are able to be manufactured by using a known method. A thin compound semiconductor stack having high mobility and excellent crystallinity in which an occurrence of excessive electrons in the vicinity of the interface between the first compound semiconductor film and the substrate is suppressed is used, and thus it is possible to obtain a semiconductor device having high performance.

### [Effect of Embodiment]

According to the embodiment of the present invention, the first compound semiconductor layer 102 which has a film thickness of greater than or equal to 0.005 µm and less than or equal to 0.2 µm, has a carbon concentration of greater than or equal to 1x10¹⁵ cm⁻³ and less than or equal to 5x10¹⁸ cm⁻³, and contains In and Sb is included between the substrate 101 and the second compound semiconductor layer 103. Accordingly, an occurrence of excessive electrons in the vicinity of the interface between the first compound semiconductor layer 102 and the substrate 101 is suppressed, and as a result thereof, the compound semiconductor multilayer film 110 having high mobility is obtained. That is, the hall generated from carbon cancels out the excessive electrons due to a defect, and thus the first compound semiconductor layer 102 exists as a high resistive layer. In addition, the first compound semiconductor layer 102 is able to relax a lattice mismatch between the substrate 101 and the second compound semiconductor layer 103, and is able to eliminate a lattice mismatch with respect to the second compound semiconductor layer 103, and thus the crystallinity of the second compound semiconductor layer 103 increases.

Thus, the first compound semiconductor layer 102 exists as the high resistive layer by cancelling out the excessive electrons and relaxes the lattice mismatch between the substrate 101 and the second compound semiconductor layer 103, and thus it is possible to realize the thin compound semiconductor multilayer film 110 having high mobility and excellent crystallinity.

### [Examples]

### [Example 1]

A 4-inch semi-insulating GaAs substrate (the substrate 101) was prepared. The electrical resistance of the semi-insulating GaAs substrate is 8x10⁷ Ωm. A first InSb layer (the first compound semiconductor layer 102) which was doped with carbon was formed on the semi-insulating GaAs substrate at 360°C by using trimethyl indium (TMIn), and trisdimethyl aminoantimony (TDMASb) as the raw material of InSb, and by using carbon tetrabromide (CBr₄) as the raw material of carbon doping. The first InSb layer which was doped with carbon was formed by using a MOCVD device.

A second InSb layer (the second compound semiconductor layer 103) was formed on the first InSb layer at 460°C by using trimethyl indium (TMIn), and trisdimethyl aminoantimony (TDMASb) as the raw material of InSb. The second InSb layer is formed by using a MOCVD device. From measurement of X-ray Fluorescence Spectrometry (XRF) using a fundamental parameter method, the entire film thickness of the InSb layer including the first InSb layer and the second InSb layer was 0.95 µm.

In addition, in order to examine a carbon concentration in the first InSb layer, a part of the film was cut out, and analysis was performed by using SIMS. As a result thereof, it was confirmed that a peak of which the maximum value was 1.0x10¹⁸ cm⁻³ was observed in the position of the first InSb layer (the first compound semiconductor layer 102), and the first InSb layer was doped with only a predetermined amount of carbon. In addition, as a thickness of the first InSb layer, a range of the thickness having a carbon concentration in measurement by using SIMS between a peak and a half-value of the peak was obtained, and it was 0.038 µm.

Hall measurement was performed with respect to a specimen formed in this way by using a van der Pauw method, and thus electron mobility of 47300 cm²/Vs and an n-type carrier concentration of 1.6x10¹⁶ cm⁻³ were obtained.

### [Example 2]

4-inch semi-insulating GaAs substrate (the substrate 101) was prepared. The electrical resistance of the semi-insulating GaAs substrate is 8x10⁷ Ωcm. A first InSb layer (the first compound semiconductor layer 102) which was doped with carbon was formed on the semi-insulating GaAs substrate at 360°C by using trimethyl indium (TMIn), and trisdimethyl aminoantimony (TDMASb) as the raw material of InSb. The first InSb layer which was doped with carbon was formed by using a MOCVD device.

The InSb layer was subjected to low temperature growth, and thus carbon was introduced to the film from a side chain of the undecomposed raw material. According to this effect, it was confirmed that the first InSb layer was doped with carbon, and the doping amount of carbon was 5x10¹⁷ cm⁻³ from SIMS measurement.

A second InSb layer (the second compound semiconductor layer 103) was formed on the first InSb layer at 460°C by using trimethyl indium (TMIn), and trisdimethyl aminoantimony (TDMASb) as the raw material of InSb. The second InSb layer was formed by using a MOCVD device. From XRF measurement, the entire film thickness of the InSb layer including the first InSb layer and the second InSb layer was 0.95 µm. In addition, as a thickness of the first InSb layer, a range of the thickness having a carbon concentration in measurement by using SIMS between a peak and a half-value of the peak was obtained, and it was 0.035 µm.

Hall measurement was performed with respect to a specimen formed in this way by using a van der Pauw method, and thus electron mobility of 48000 cm²/Vs and an n-type carrier concentration of 1.7x10¹⁶ cm⁻³ were obtained.

### [Example 3]

4-inch semi-insulating GaAs substrate (the substrate 101) was prepared. The electrical resistance of the semi-insulating GaAs substrate is 8x10⁷ Ωcm. A first InSb layer (the first compound semiconductor layer 102) which was doped with carbon was formed on the semi-insulating GaAs substrate at 360°C by using trimethyl indium (TMIn), and trisdimethyl aminoantimony (TDMASb) as the raw material of InSb, and by using carbon tetrabromide (CBr₄) as the raw material of carbon doping. The first InSb layer which was doped with carbon was formed by using a MOCVD device. In the first InSb layer, the doping amount of carbon was 1x10¹⁸ cm⁻³ from SIMS measurement.

A second InSb layer (the second compound semiconductor layer 103) was formed on the first InSb layer at 460°C by using trimethyl indium (TMIn), and trisdimethyl aminoantimony (TDMASb) as the raw material of InSb. The second InSb layer is formed by using a MOCVD device. From XRF measurement, the entire film thickness of the InSb layer including the first InSb layer and the second InSb layer was 0.93 µm. In addition, as a thickness of the first InSb layer, a range of the thickness having a carbon concentration in measurement by using SIMS between a peak and a half-value of the peak was obtained, and it was 0.008 µm.

Hall measurement was performed with respect to a specimen formed in this way by using a van der Pauw method, and thus electron mobility of 40800 cm²/Vs and an n-type carrier concentration of 2.1x10¹⁶ cm⁻³ were obtained.

### [Example 4]

4-inch semi-insulating GaAs substrate (the substrate 101) was prepared. The electrical resistance of the semi-insulating GaAs substrate is 8x10⁷ Ωcm. A first InSb layer (the first compound semiconductor layer 102) which was doped with carbon was formed on the semi-insulating GaAs substrate at 360°C by using trimethyl indium (TMIn), and trisdimethyl aminoantimony (TDMASb) as the raw material of InSb, and by using carbon tetrabromide (CBr₄) as the raw material of carbon doping. The first InSb layer which was doped with carbon was formed by using a MOCVD device. In the first InSb layer, the doping amount of carbon was 1x10¹⁸ cm⁻³ from SIMS measurement.

A second InSb layer (the second compound semiconductor layer 103) was formed on the first InSb layer at 460°C by using trimethyl indium (TMIn), and trisdimethyl aminoantimony (TDMASb) as the raw material of InSb. The second InSb layer is formed by using a MOCVD device. From XRF measurement, the entire film thickness of the InSb layer including the first InSb layer and the second InSb layer was 0.95 µm. In addition, as a thickness of the first InSb layer, a range of the thickness having a carbon concentration in measurement by using SIMS between a peak and a half-value of the peak was obtained, and it was 0.20 µm.

Hall measurement was performed with respect to a specimen formed in this way by using a van der Pauw method, and thus electron mobility of 35600 cm²/Vs and an n-type carrier concentration of 1.7x10¹⁶ cm⁻³ were obtained.

### [Example 5]

4-inch semi-insulating GaAs substrate (the substrate 101) was prepared. The electrical resistance of the semi-insulating GaAs substrate is 8x10⁷ Ωcm. A first InSb layer (the first compound semiconductor layer 102) which was doped with carbon was formed on the semi-insulating GaAs substrate at 360°C by using trimethyl indium (TMIn), and trisdimethyl aminoantimony (TDMASb) as the raw material of InSb, and by using carbon tetrabromide (CBr₄) as the raw material of carbon doping. The first InSb layer which was doped with carbon was formed by using a MOCVD device. In the first InSb layer, the doping amount of carbon was 4x10¹⁶ cm⁻³ from SIMS measurement.

A second InSb layer (the second compound semiconductor layer 103) was formed on the first InSb layer at 460°C by using trimethyl indium (TMIn), and trisdimethyl aminoantimony (TDMASb) as the raw material of InSb. The second InSb layer is formed by using a MOCVD device. From XRF measurement, the entire film thickness of the InSb layer including the first InSb layer and the second InSb layer was 0.95 µm. In addition, as a thickness of the first InSb layer, a range of the thickness having a carbon concentration in measurement by using SIMS between a peak and a half-value of the peak was obtained, and it was 0.028 µm.

Hall measurement was performed with respect to a specimen formed in this way by using a van der Pauw method, and thus electron mobility of 30500 cm²/Vs and an n-type carrier concentration of 2.6x10¹⁶ cm⁻³ were obtained.

### [Example 6]

4-inch semi-insulating GaAs substrate (the substrate 101) was prepared. The electrical resistance of the semi-insulating GaAs substrate is 8x10⁷ Ωcm. A first InSb layer (the first compound semiconductor layer 102) which was doped with carbon was formed on the semi-insulating GaAs substrate at 240°C by using trimethyl indium (TMIn), and trisdimethyl aminoantimony (TDMASb) as the raw material of InSb. The first InSb layer which was doped with carbon was formed by using a MOCVD device.

The InSb layer was subjected to low temperature growth, and thus carbon was introduced to the film from a side chain of the undecomposed raw material as with Example 2, but the growth temperature was lower than that of Example 2, and thus it was confirmed that the first InSb layer was doped with a larger amount of carbon, and the doping amount of carbon was 2x10¹⁸ cm⁻³ from SIMS measurement.

A second InSb layer (the second compound semiconductor layer 103) was formed on the first InSb layer at 460°C by using trimethyl indium (TMIn), and trisdimethyl aminoantimony (TDMASb) as the raw material of InSb. The second InSb layer was formed by using a MOCVD device. From XRF measurement, the entire film thickness of the InSb layer including the first InSb layer and the second InSb layer was 0.98 µm. In addition, as a thickness of the first InSb layer, a range of the thickness having a carbon concentration in measurement by using SIMS between a peak and a half-value of the peak was obtained, and it was 0.038 µm.

Hall measurement was performed with respect to a specimen formed in this way by using a van der Pauw method, and thus electron mobility of 55600 cm²/Vs and an n-type carrier concentration of 1.6x10¹⁶ cm⁻³ were obtained.

### [Comparative Example 1]

A first InSb layer was formed on a 4-inch semi-insulating GaAs substrate (electrical resistance: 8x10⁷ Ωcm) at 460°C by using trimethyl indium (TMIn), and trisdimethyl aminoantimony (TDMASb) as the raw material of InSb in the same condition as that of Example 1 except that a carbon dopant was not used. The first InSb layer which was not doped with carbon was formed by using a MOCVD device.

A second InSb layer was formed on the first InSb layer at 460°C by using trimethyl indium (TMIn), and trisdimethyl aminoantimony (TDMASb) as the raw material of InSb. From XRF measurement, the entire film thickness of the InSb layer including the first InSb layer and the second InSb layer was 0.95 µm. In addition, measurement of a carbon concentration was performed by using SIMS, and a region in which the amount of carbon was greater than or equal to the lower limit value of detection sensitivity of SIMS measurement was not observed in a portion of the first InSb layer.

Hall measurement was performed with respect to a specimen formed in this way by using a van der Pauw method, and thus electron mobility of 23000 cm²/Vs and an n-type carrier concentration of 3.4x10¹⁶ cm⁻³ were obtained.

### [Comparative Example 2]

A 4-inch semi-insulating GaAs substrate (the substrate 101) was prepared. The electrical resistance of the semi-insulating GaAs substrate is 8x10⁷ Ωcm. A first InSb layer (the first compound semiconductor layer 102) was formed on the semi-insulating GaAs substrate at 460°C by using trimethyl indium (TMIn), and trisdimethyl aminoantimony (TDMASb) as the raw material of InSb, by using carbon tetrabromide (CBr₄) as the raw material of carbon doping, and by adjusting the concentration of carbon to be 6x10¹⁴ cm⁻³. The first InSb layer which was doped with carbon was formed by using a MOCVD device.

A second InSb layer was formed on the first InSb layer at 460°C by using trimethyl indium (TMIn), and trisdimethyl aminoantimony (TDMASb) as the raw material of InSb. From XRF measurement, the entire film thickness of the InSb layer including the first InSb layer and the second InSb layer was 0.95 µm. In this comparative example, a region in which the amount of carbon was greater than or equal to the lower limit value of detection sensitivity of SIMS measurement was not observed in the first InSb layer.

Hall measurement was performed with respect to a specimen formed in this way by using a van der Pauw method, and thus electron mobility of 23500 cm²/Vs and an n-type carrier concentration of 2.8x10¹⁶ cm⁻³ were obtained.

### [Comparative Example 3]

A 4-inch semi-insulating GaAs substrate (the substrate 101) was prepared. The electrical resistance of the semi-insulating GaAs substrate is 8x10⁷ Ωcm. A first InSb layer (the first compound semiconductor layer 102) was formed on the semi-insulating GaAs substrate at 460°C by using trimethyl indium (TMIn), and trisdimethyl aminoantimony (TDMASb) as the raw material of InSb, by using carbon tetrabromide (CBr₄) as the raw material of carbon doping, and by adjusting the flow rate of carbon such that the amount of carbon is greater than 5x10¹⁸ cm⁻³. The first InSb layer which was doped with carbon was formed by using a MOCVD device. In the first InSb layer, the doping amount of carbon was 5x10²⁰ cm⁻³ from SIMS measurement.

A second InSb layer (the second compound semiconductor layer 103) was formed on the first InSb layer at 460°C by using trimethyl indium (TMIn), and trisdimethyl aminoantimony (TDMASb) as the raw material of InSb. The second InSb layer was formed by using a MOCVD device. From XRF measurement, the entire film thickness of the InSb layer including the first InSb layer and the second InSb layer was 0.98 µm. In addition, as a thickness of the first InSb layer, a range of the thickness having a carbon concentration in measurement by using SIMS between a peak and a half-value of the peak was obtained, and it was 0.045 µm.

Hall measurement was performed with respect to a specimen formed in this way by using a van der Pauw method, and thus electron mobility of 9800 cm²/Vs and an n-type carrier concentration of 4.0x10¹⁷ cm⁻³ were obtained.

### [Comparative Example 4]

A 4-inch semi-insulating GaAs substrate (the substrate 101) was prepared. The electrical resistance of the semi-insulating GaAs substrate is 8x10⁷ Ωcm. A first InSb layer (the first compound semiconductor layer 102) was formed on the semi-insulating GaAs substrate at 460°C by using trimethyl indium (TMIn), and trisdimethyl aminoantimony (TDMASb) as the raw material of InSb, and by using carbon tetrabromide (CBr₄) as the raw material of carbon doping. The first InSb layer which was doped with carbon was formed by using a MOCVD device. In the first InSb layer, the doping amount of carbon was 3x10¹⁶ cm⁻³ from SIMS measurement.

A second InSb layer (the second compound semiconductor layer 103) was formed on the first InSb layer at 460°C by using trimethyl indium (TMIn), and trisdimethyl aminoantimony (TDMASb) as the raw material of InSb. The second InSb layer was formed by using a MOCVD device. From XRF measurement, the entire film thickness of the InSb layer including the first InSb layer and the second InSb layer was 0.93 µm. In addition, as a thickness of the first InSb layer, a range of the thickness having a carbon concentration in measurement by using SIMS between a peak and a half-value of the peak was obtained, and it was 0.004 µm.

Hall measurement was performed with respect to a specimen formed in this way by using a van der Pauw method, and thus electron mobility of 25500 cm²/Vs and an n-type carrier concentration of 2.3x10¹⁶ cm⁻³ were obtained.

### [Comparative Example 5]

A 4-inch semi-insulating GaAs substrate (the substrate 101) was prepared. The electrical resistance of the semi-insulating GaAs substrate is 8x10⁷ Ωcm. A first InSb layer (the first compound semiconductor layer 102) which was doped with carbon was formed on the semi-insulating GaAs substrate at 400°C by using trimethyl indium (TMIn), and trisdimethyl aminoantimony (TDMASb) as the raw material of InSb. The first InSb layer which was doped with carbon was formed by using a MOCVD device. The InSb layer was subjected to low temperature growth, and thus carbon was introduced to the film from a side chain of the undecomposed raw material as with Example 2, but the ratio was less than that of Example 2, and it was confirmed that the doping amount of carbon in the first InSb layer was 8x10¹⁴ cm⁻³ from SIMS measurement.

A second InSb layer (the second compound semiconductor layer 103) was formed on the first InSb layer at 460°C by using trimethyl indium (TMIn), and trisdimethyl aminoantimony (TDMASb) as the raw material of InSb. The second InSb layer was formed by using a MOCVD device. From XRF measurement, the entire film thickness of the InSb layer including the first InSb layer and the second InSb layer was 0.93 µm. In addition, as a thickness of the first InSb layer, a range of the thickness having a carbon concentration in measurement by using SIMS between a peak and a half-value of the peak was obtained, and it was 0.017 µm.

Hall measurement was performed with respect to a specimen formed in this way by using a van der Pauw method, and thus electron mobility of 27000 cm²/Vs and an n-type carrier concentration of 2.2x10¹⁶ cm⁻³ were obtained.

### [Result of Comparison]

From the results described above, the excessive electrons generated by the defect in the vicinity of the interface were cancelled out by including the first compound semiconductor layer which had a film thickness of greater than or equal to 0.005 µm and less than or equal to 0.2 µm, had a carbon concentration of greater than or equal to 1x10¹⁵ cm⁻³ and less than or equal to 5x10¹⁸ cm⁻³, and included In and Sb and the second compound semiconductor layer which had a carbon concentration less than that of the first compound semiconductor layer, and included In and Sb, and thus it was confirmed that the carrier concentration of the entire compound semiconductor multilayer film was decreased, and the electron mobility was improved.

### Industrial Applicability

The compound semiconductor multilayer film of the present invention containing In and Sb is suitable as a compound semiconductor multilayer film for a magnetic sensor and an infrared sensor.

### Reference Signs List

- 10: COMPOUND SEMICONDUCTOR STACK
- 101: SUBSTRATE
- 102: FIRST COMPOUND SEMICONDUCTOR LAYER
- 103: SECOND COMPOUND SEMICONDUCTOR LAYER
- 110: COMPOUND SEMICONDUCTOR MULTILAYER FILM

## Claims

1. A compound semiconductor stack, comprising:
a substrate having electrical resistance greater than or equal to 1x10⁵ Ωcm;
a first compound semiconductor layer formed on the substrate, comprising In and Sb doped with carbon; and
a second compound semiconductor layer formed on the first compound semiconductor layer, having a carbon concentration less than a carbon concentration of the first compound semiconductor layer, and comprising In and Sb,
wherein a film thickness of the first compound semiconductor layer is greater than or equal to 0.005 µm and less than or equal to 0.2 µm, and the carbon concentration of the first compound semiconductor layer is greater than or equal to 1x10¹⁵ cm⁻³ and less than or equal to 5x10¹⁸ cm⁻³.

2. The compound semiconductor stack according to claim 1, wherein the substrate is Si or GaAs.

3. The compound semiconductor stack according to claim 1 or 2, wherein the first compound semiconductor layer is a buffer layer relaxing a lattice mismatch between the substrate and the second compound semiconductor layer, and
the second compound semiconductor layer is an active layer functioning as at least a part of an element.

4. A semiconductor device obtained by using the compound semiconductor stack according to any one of claims 1 to 3.
